# EUROPEAN PATENT APPLICATION

(11) **EP 4 642 160 A1**
(43) Date of publication of application: **29.10.2025**
(21) Application number: 23905362.2
(22) Date of filing: 26.09.2023
(51) Int. Cl.: H05B 6/12, A47J 27/00

(54) **POT DETECTION CIRCUIT AND METHOD, POWER CONTROL CIRCUIT AND METHOD, AND WIRELESS HEATING APPARATUS**

(30) Priority: 22.12.2022 CN 202211658692; 30.08.2023 CN 202311109380
(71) Applicant: Foshan Shunde Midea Electrical Heating Appliances Manufacturing Co., Ltd., Foshan, Guangdong 528311 (CN)
(72) Inventor: WANG, Zhifeng, Foshan, Guangdong 528311 (CN); ZENG, Feng, Foshan, Guangdong 528311 (CN); ZENG, Xianguang, Foshan, Guangdong 528311 (CN); LI, Hang, Foshan, Guangdong 528311 (CN); KONG, Jieying, Foshan, Guangdong 528311 (CN); LIU, Wenhua, Foshan, Guangdong 528311 (CN)
(74) Representative: Ran, Handong
(86) International application number: PCT/CN2023/121564
(87) International publication number: WO 2024/131189

(57) **Abstract**

The present application discloses a pot detection circuit and method, a power control circuit and method, and a wireless heating apparatus. The pot detection circuit comprises a direction detection module, a voltage detection module, and a control module. The control module is connected to the direction detection module and the voltage detection module, and is used to determine a voltage amplitude of a first capacitor according to a direction signal corresponding to a current direction flowing through a first resistor inputted by the direction detection module and a voltage signal corresponding to a capacitance voltage of the first capacitor inputted by the voltage detection module, and determine, according to a comparison result between the voltage amplitude and a preset amplitude, whether the wireless heating apparatus carries a pot. By means of obtaining an actual voltage amplitude of the first capacitor connected in series with a coil and determining, on the basis of the comparison result between the voltage amplitude and the preset amplitude, whether the wireless heating apparatus carries a pot, interference from an external magnetic field on a circuit in the wireless heating apparatus can be avoided, thereby making a detection result of the pot more accurate.

## Description

### CROSS-REFERENCE TO RELATED APPLICATIONS

This application claims priority to Chinese Patent Application No. 202211658692. X filed on December 22, 2022 and Chinese Patent Application No. 202311109380.8 filed on August 30, 2023, the entire contents of which are incorporated herein by reference for all purposes.

### TECHNICAL FIELD

The application relates to the technical field of wireless powering, and in particular to, a pot detection circuit, a power control circuit, corresponding methods, and a wireless heating apparatus.

### BACKGROUND

Wireless heating apparatuses are increasingly widely used in people's daily life because of their convenience and practicality. In general, in order to protect a heating circuit, before heating a pot, the wireless heating apparatus determines whether it carries the pot by obtaining a number of reversals of a current flowing through the coil within a certain period of time. In this way, the pot is not heated until it is determined that the pot is carried, so as to prevent electronic components from being damaged due to excessive current in the wireless heating apparatus.

### SUMMARY

In view of the above, the application provides a pot detection circuit, a power control circuit, corresponding methods, and a wireless heating apparatus, so as to alleviate the problem above.

According to a first aspect, embodiments of the application provide a pot detection circuit, applied to a wireless heating apparatus used for heating a carried pot. The wireless heating apparatus includes a heating coil, a first resistor and a first capacitor sequentially connected in series, and the pot detection circuit includes a direction detection module, a voltage detection module and a control module. The direction detection module is connected to two ends of the first resistor, and configured to detect a current direction of a current flowing through the first resistor; the voltage detection module is connected to an end of the first capacitor, and configured to detect a capacitor voltage of the first capacitor; and the control module is connected to the direction detection module and the voltage detection module, and configured to determine a voltage amplitude of the first capacitor according to a direction signal corresponding to the current direction input by the direction detection module and a voltage signal corresponding to the capacitor voltage input by the voltage detection module, and determine whether the wireless heating apparatus carries a pot according to a comparison result of the voltage amplitude and a preset amplitude.

According to a second aspect, embodiments of the application provide a power control circuit, applied to a wireless heating apparatus used for heating a carried pot. The wireless heating apparatus includes a heating coil, a first resistor and a first capacitor sequentially connected in series, and the power control circuit includes a direction detection module, a voltage detection module and a control module. The direction detection module is connected to two ends of the first resistor, and configured to detect a current direction of a current flowing through the first resistor; the voltage detection module is connected to an end of the first capacitor, and configured to detect a capacitor voltage of the first capacitor; and the control module is connected to the direction detection module and the voltage detection module, and configured to determine a voltage amplitude of the first capacitor according to a direction signal corresponding to the current direction input by the direction detection module and a voltage signal corresponding to the capacitor voltage input by the voltage detection module, and control a heating power of the wireless heating apparatus according to a comparison result of the voltage amplitude and a target amplitude corresponding to a present heating power of the wireless heating apparatus.

According to a third aspect, embodiments of the application provide a pot detection method, applied to a wireless heating apparatus for heating a carried pot. The wireless heating apparatus includes a heating coil, and a first resistor and a first capacitor connected in series with the heating coil. The pot detection method includes: obtaining a direction signal and a voltage signal, wherein the direction signal is used for characterizing a current direction of a current flowing through the first resistor, and the voltage signal is used for characterizing a capacitor voltage of the first capacitor; determining a voltage amplitude of the first capacitor based on the direction signal and the voltage signal; and determining whether the wireless heating apparatus carries a pot based on a comparison result of the voltage amplitude and a preset amplitude.

According to a fourth aspect, embodiments of the application provide a power control method, applied to a wireless heating apparatus for heating a carried pot. The wireless heating apparatus includes a heating coil, and a first resistor and a first capacitor connected in series with the heating coil. The power control method includes: obtaining a direction signal and a voltage signal, wherein the direction signal is used for characterizing a current direction of a current flowing through the first resistor, and the voltage signal is used for characterizing a capacitor voltage of the first capacitor; determining a voltage amplitude of the first capacitor based on the direction signal and the voltage signal; and controlling a heating power of the wireless heating apparatus based on a comparison result of the voltage amplitude and a target amplitude corresponding to a present heating power of the wireless heating apparatus.

According to a fifth aspect, embodiments of the application provide a wireless heating apparatus. The wireless heating apparatus includes a heating coil, a first resistor, a first capacitor, and a pot detection circuit provided in the first aspect above. The heating coil, the first resistor and the first capacitor are sequentially connected in series.

According to a sixth aspect, embodiments of the application provide a wireless heating apparatus. The wireless heating apparatus includes a heating coil, a first resistor, a first capacitor, and a power control circuit provided in the first aspect above. The heating coil, the first resistor and the first capacitor are sequentially connected in series.

### BRIEF DESCRIPTION OF THE DRAWINGS

In order to more clearly explain the technical solutions in the embodiments of the application, the accompanying drawings that need to be used in the description of the embodiments will be briefly introduced below, and it is apparent that the accompanying drawings in the following description are only related to some embodiments of the application, and for those skilled in the art, other accompanying drawings can be obtained from these accompanying drawings without creative efforts.
FIG. 1 shows a schematic structural diagram of a pot detection circuit according to an embodiment of the application.
FIG. 2 is a schematic diagram showing a specific structure of a direction detection module according to an embodiment of the application.
FIG. 3 is a schematic diagram showing a specific structure of a voltage detection module according to an embodiment of the application.
FIG. 4 shows a schematic structural diagram of a power control circuit according to an embodiment of the application.
FIG. 5 is a schematic diagram showing a specific structure of a direction detection module according to an embodiment of the application.
FIG. 6 is a schematic diagram showing a specific structure of a voltage detection module according to an embodiment of the application.
FIG. 7 is a schematic flowchart of a pot detection method according to an embodiment of the application.
FIG. 8 is a schematic diagram showing a specific flowchart of operation S120 in the pot detection method according to the embodiment of the application.
FIG. 9 is a schematic diagram showing a specific flowchart of operation S130 in the pot detection method according to the embodiment of the application.
FIG. 10 is a schematic flowchart of a power control method according to an embodiment of the application.
FIG. 11 is a schematic diagram showing a specific flowchart of operation S220 in the power control method according to the embodiment of the application.
FIG. 12 is a schematic diagram showing a specific flowchart of operation S230 in the power control method according to the embodiment of the application.
FIG. 13 shows a schematic structural diagram of a wireless heating apparatus according to an embodiment of the application.
FIG. 14 shows another schematic structural diagram of a wireless heating apparatus according to an embodiment of the application.

### DETAILED DESCRIPTION

In order to enable those skilled in the art to better understand the solutions of the application, the technical solutions in the embodiments of the application will be clearly and completely described below with reference to the drawings in the embodiments of the application.

In the field of wireless heating technology, a carried pot is usually heated by a coil in a wireless heating apparatus. By applying an alternating current with a certain frequency at both ends of the coil, an alternating magnetic field will be generated. If the pot is placed in the alternating magnetic field, an induced current will be generated inside the pot, which can heat objects inside the pot. If the wireless heating apparatus carries a pot, the pot will absorb most of the power of the coil to heat the objects inside the pot. However, if the wireless heating apparatus does not carry the pot, the power from the coil will not be absorbed by an external object, which will result in a large current in a circuit of the wireless heating apparatus, and easily lead to damage to electronic components in the circuit, such as Insulated Gate Bipolar Transistor (IGBT). Therefore, in general, the wireless heating apparatus will detect, by some means, whether it carries a pot before heating the pot.

In the related art, the wireless heating apparatus obtains a number of reversals of the current in the coil by a current transformer, and determines whether the wireless heating apparatus carries a pot based on the number of reversals. It can be understood that with a same heating power, if there are no other influencing factors, the number of reversals of the current in the circuit when the pot is carried will be significantly less than the number of reversals of the current in the circuit when the pot is not carried. However, this detection method is not accurate, because while the coil heats the pot, it will also be disturbed by an external magnetic field, and the pot may absorb energy from the disturbance, resulting in an increase in the number of current reversals. In particular, when multiple heating apparatuses perform heating at the same time, the influence on the coil is particularly significant, and in this case, the detection result regarding whether the pot is carried determined based on the number of current reversals is not accurate.

In order to alleviate the problems above, the applicant proposes a pot detection circuit, a corresponding method and a wireless heating apparatus according to embodiments of the application. The pot detection circuit includes a direction detection module, a voltage detection module and a control module. The control module is connected to the direction detection module and the voltage detection module. The control module is configured to determine a voltage amplitude of a first capacitor according to: a direction signal corresponding to a current direction of a current flowing through a first resistor, which is input by the direction detection module, and a voltage signal corresponding to a capacitor voltage of the first capacitor, which is input by the voltage detection module; and determine whether the wireless heating apparatus carries a pot according to a comparison result of the voltage amplitude and a preset amplitude. By obtaining an actual voltage amplitude of the first capacitor connected in series with the coil, and determining whether the wireless heating apparatus carries the pot based on the comparison result of the voltage amplitude and the preset amplitude, it is possible to avoid the interference of the external magnetic field on the coil, and obtain a more accurate pot detection result.

In order to enable those skilled in the art to better understand the solutions of the application, the technical solutions in the embodiments of the application will be clearly and completely described below with reference to the drawings in the embodiments of the application. Obviously, the embodiments described are only part of the embodiments of the application, but not all embodiments. Based on the embodiments in the application, all other embodiments obtained by those skilled in the art without creative efforts fall within the scope of protection of the application.

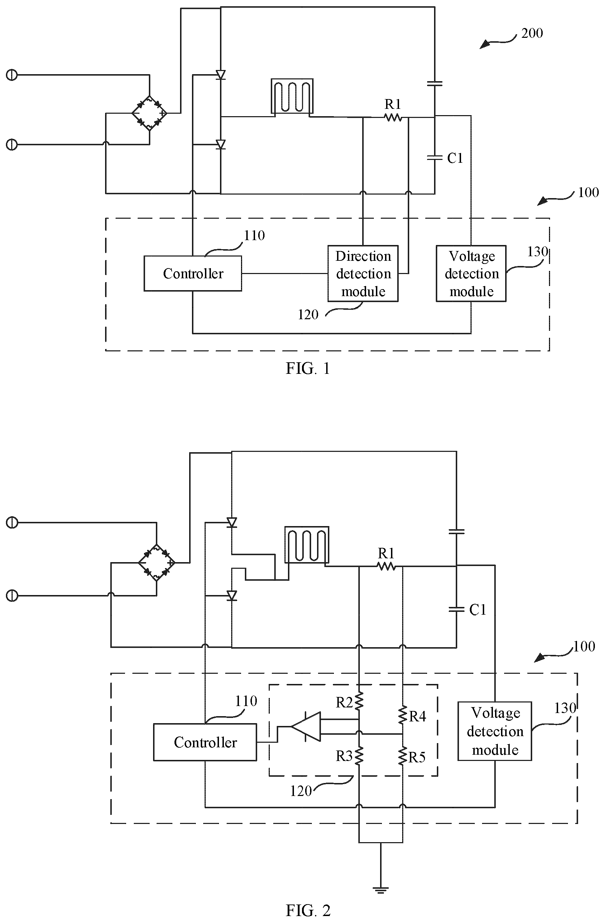

With reference to FIG. 1, it shows a schematic structural diagram of a pot detection circuit according to an embodiment of the application. The pot detection circuit 100 is applied to a wireless heating apparatus 200 used for heating a carried pot. The wireless heating apparatus 200 includes a heating coil, a first resistor R1 and a first capacitor C1 sequentially connected in series. The pot detection circuit 100 includes: a direction detection module 120 connected to two ends of the first resistor R1, and configured to detect a current direction of a current flowing through the first resistor R1; a voltage detection module 130 connected to an end of the first capacitor C1, and configured to detect a capacitor voltage of the first capacitor C1; and a control module 100 connected to the direction detection module 120 and the voltage detection module 130, and configured to determine a voltage amplitude of the first capacitor C1 according to a direction signal corresponding to the current direction input by the direction detection module 120 and a voltage signal corresponding to the capacitor voltage input by the voltage detection module 130, and determine whether the wireless heating apparatus 200 carries a pot according to a comparison result of the voltage amplitude and a preset amplitude.

In the embodiment of the application, during heating of the pot by the wireless heating apparatus 200, the control module 110 of the pot detection circuit 100 may obtain, through the direction detection module 120, the direction signal corresponding to the current direction of the current flowing through the first resistor R1 and obtain, through the voltage detection module 130, the voltage signal corresponding to the capacitor voltage of the first capacitor C1, determine the voltage amplitude of the first capacitor C1 based on the direction signal and the voltage signal, and determine whether the wireless heating apparatus 200 carries a pot based on the comparison result of the voltage amplitude and the preset amplitude. It can be understood that with a same heating power, the voltage amplitudes of the first capacitor C1 are significantly different in cases where the wireless heating apparatus 200 carries a pot or does not carry a pot. Specifically, if the wireless heating apparatus 200 carries a pot, the pot absorbs most of the heating power from the wireless heating apparatus 200, so that the remaining power in the circuit of the wireless heating apparatus 200 is relatively small, and the voltage amplitude of the first capacitor C1 connected in series with the coil becomes small accordingly. However, if the wireless heating apparatus 200 does not carry a pot, the heating power in the wireless heating apparatus 200 is not absorbed by an external device, and the power remaining in the circuit is large, which causes the voltage amplitude of the first capacitor C1 connected in series with the coil to increase. Therefore, the controller in the pot detection circuit 100 can detect the voltage amplitude of the first capacitor C1, compare the voltage amplitude with the preset amplitude, and accurately determine whether the wireless heating apparatus 200 carries a pot.

It can be understood that with the pot detection circuit 100, the reference parameter for determining whether a pot is carried changes from the number of current reversals of the coil to the voltage amplitude of the first capacitor C1, thus the influence of the external magnetic field on the number of current reversals of the coil can be effectively avoided. Moreover, by directly measuring the voltage amplitude of the first capacitor C1 connected in series with the coil, it is not necessary to additionally add a current transformer to obtain the number of current reversals, that is, it is possible to reduce the number of circuit components and reduce the cost of the circuit. Furthermore, the voltage amplitude of the first capacitor C1 is less easily affected by the external environment, which can make the pot detection result more accurate.

Specifically, the control module 110 of the pot detection circuit 100 is configured to determine that the wireless heating apparatus 200 does not carry a pot when the voltage amplitude is greater than the preset amplitude, and determine that the wireless heating apparatus 200 carries a pot when the voltage amplitude is less than or equal to the preset amplitude.

That is to say, if the voltage amplitude of the first capacitor C1 is larger than the preset amplitude, it indicates that there is a large amount of remaining power in the circuit of the wireless heating apparatus 200 at this time, and no large amount of power is absorbed by the external pot when the heating power is fixed, so it can be determined that the wireless heating apparatus 200 does not carry the pot at this time. Similarly, if the voltage amplitude of the first capacitor C1 is less than or equal to the preset amplitude, it indicates that more power in the circuit of the wireless heating apparatus 200 is absorbed by the externally carried pot, and less power remains in the circuit. At this time, the controller may determine that the wireless heating apparatus 200 carries a pot.

It can be understood that the determination of the preset amplitude determines whether the judgment of the existence of a pot is accurate. The user can obtain different voltage amplitudes of the first capacitor C1 when different pots are carried through experiments made based on different heating powers in advance, thereby determining the preset amplitude. The specific experimental method may not be limited herein.

In some implementations, the direction signal includes a first direction signal and a second direction signal, and the control module 110 is further configured to use, as a first peak signal, the voltage signal at a present time when a received direction signal changes from the second direction signal to the first direction signal, and use, as a second peak signal, the voltage signal at a present time when the received direction signal changes from the first direction signal to the second direction signal; and the control module 110 is further configured to determine the voltage amplitude of the first capacitor C1 based on the first peak signal and the second peak signal.

It can be understood that the voltage of the first capacitor C1 is alternating, and the voltage amplitude corresponding to the first capacitor C1 should be a difference between a maximum value of the positive half-cycle voltage and a maximum value of the negative half-cycle voltage of the first capacitor C1. Thus, the controller can accurately determine occurrence times of the maximum value of the positive half-cycle voltage and the maximum value of the negative half-cycle voltage through the direction signals obtained by the direction detection module 120. That is to say, when the direction signal received by the controller changes from the first direction signal to the second direction signal, the voltage signal of the first capacitor C1 at this time happens to be a peak signal, and the voltage signal at this time can be used as the first peak signal corresponding to the first capacitor C1. Similarly, when the direction signal changes from the second direction signal to the first direction signal, the voltage signal of the first capacitor C1 also happens to be a peak signal at this time, and the voltage signal at this time can be used as the second peak signal corresponding to the first capacitor C1. As can be seen, when the direction signals have different directions of change, the voltage signals of the first capacitor C1 will also have different directions. Thus, the controller can determine the voltage amplitude of the first capacitor C1 based on the two different peak signals.

Specifically, the control module 110 may determine an absolute value of a difference between the first peak signal and the second peak signal, and use the absolute value as the voltage amplitude.

As can be seen, the first resistor R1 and the first capacitor C1 are connected in series, and the voltage of the first capacitor C1 happens to be at a peak value when the direction signal corresponding to the current direction of the first resistor R1 changes, so both the first peak signal and the second peak signal can represent peak values of the voltage signal of the first capacitor C1. Further, if the direction signals have different directions of change, the voltage signals of the first capacitor C1 will also have different directions, and thus the first peak signal and the second peak signal determined based on the different change situations of the direction signal are also different. In this way, the controller may use the absolute value of the difference between the first peak signal and the second peak signal as the voltage amplitude corresponding to the first capacitor C1.

In the embodiment of the application, as shown in FIG. 2, the direction detection module 120 includes a first detection port, a second detection port, and a first output port. The first detection port is connected to a first end of the first resistor R1, the second detection port is connected to a second end of the first resistor R1, and the first output port is connected to a first input port of the control module 110; the direction detection module 120 is configured to obtain a first voltage at the first end of the first resistor R1 through the first detection port, and obtain a second voltage at the second end of the first resistor R1 through the second detection port; and the direction detection module 120 is further configured to output different direction signals to the first input port through the first output port according to a comparison result of the first voltage and the second voltage, the direction signal being used for characterizing the current direction of the current flowing through the first resistor R1.

It can be understood that the direction signal obtained by the controller is used for characterizing the current direction of the current flowing through the first resistor R1, and it is obvious that the current direction of the current flowing through the first resistor R1 includes two directions. Therefore, the direction signal obtained by the controller also includes the first direction signal and the second direction signal, which are respectively used for characterizing different current directions of the current flowing through the first resistor R1. Herein, the direction detection module 120 may obtain a voltage at the first end of the first resistor R1 through the first detection port, and obtain a voltage at the second end of the first resistor R1 through the second detection port; and determine current directions of the current flowing through the first resistor R1 at different times through a relation between voltages at both ends of the first resistor R1. Herein, the direction detection module may determine that the current direction of the current flowing through the first resistor R1 is a first direction when it is detected that the voltage at the first end of the first resistor R1 is greater than the voltage at its second end, and determine that the current direction of the current flowing through the first resistor R1 is a second direction when the voltage at the first end of the first resistor R1 is less than or equal to the voltage at its second end. Then, the direction detection module may output corresponding direction signals to the first input port through the first output port based on different current directions.

In some implementations, the direction detection module 120 may include a second resistor R2 and a third resistor R3. One end of the third resistor R3 is grounded, and the other end of the third resistor R3 is connected to one end of the second resistor R2 and the first detection port of the direction detection module 120. The other end of the second resistor R2 is connected to the first end of the first resistor R1. The direction detection module 120 may obtain, as the first voltage, the voltage at the first end of the first resistor R1 after voltage dividing through the second resistor R2 and the third resistor R3. Similarly, the direction detection module 120 may further include a fourth resistor R4 and a fifth resistor R5. One end of the fifth resistor R5 is grounded, and the other end of the fifth resistor R5 is connected to one end of the fourth resistor R4 and the second detection port of the direction detection module 120. The other end of the fourth resistor R4 is connected to the second end of the first resistor R1. The direction detection module 120 may obtain, as the second voltage, the voltage at the second end of the first resistor R1 after voltage dividing through the fourth resistor R4 and the fifth resistor R5.

In some implementations, the direction detection circuit 120 may further includes a first comparator, a positive input end of the first comparator serving as the first detection port, a negative input end of the first comparator serving as the second detection port, and an output end of the first comparator serving as the first output port of the direction detection module 120. When the first voltage obtained by the positive input end is larger than the second voltage obtained by the negative input end, the first comparator may output a first level signal to the first input port of the control module 110 through the output end, and at this time, the first level signal may be used as the first direction signal. Moreover, when the first voltage obtained by the positive input end is less than or equal to the second voltage obtained by the negative input end, the first comparator may output a second level signal to the first input port of the control module 110 through the output end, and at this time, the second level signal may be used as the second direction signal. Accordingly, the direction detection module 120 may obtain the current direction of the current flowing through the first resistor R1 in real time, and output the current direction to the control module 110 in the form of the first direction signal and the second direction signal.

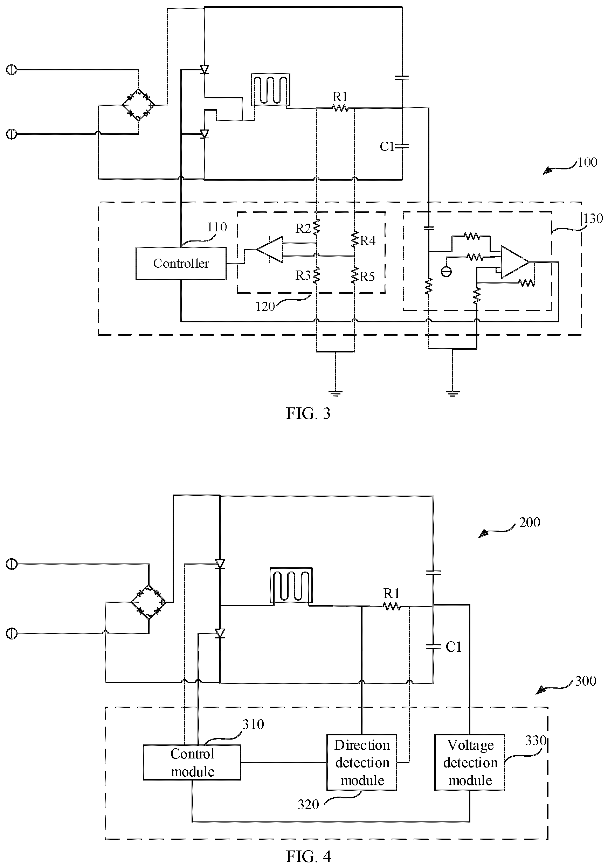

In the embodiment of the application, as shown in FIG. 3, the direction detection module 130 includes a third detection port and a second output port. The third detection port is connected to the end of the first capacitor C1, and the second output port is connected to a second input port of the control module 110. The direction detection module 130 is configured to obtain the capacitor voltage of the first capacitor C1 through the third detection port, and transmit the voltage signal corresponding to the capacitor voltage to the second input port through the second output port.

It can be understood that the voltage signal obtained by the control module 110 should be a digital signal, and the voltage detection module 130 is connected between the control module 110 and the first capacitor C1, it is then necessary to convert the analog voltage signal across the first capacitor C1 into a digital voltage signal that can be recognized by the control module 110. Specifically, the voltage detection module 130 may include an adder, one input port of a positive input end of the adder may be connected to one end of the first capacitor C1 as the third detection port, and the other input port of the positive input end of the adder may be connected to an external power source. As can be understood, the control module 110 cannot recognize a negative voltage, and the voltage at the first capacitor C1 varies in the form of a sine wave between a maximum voltage value and a minimum voltage value, where the minimum voltage value is negative, for example, the voltage at the first capacitor C1 may fluctuate in the form of a sine wave between - 1. 5 V and +1.5 V. At this time, the adder can pull up the voltage at the positive input end of the adder to a positive voltage through the external power supply connected to the other input port, for example, the voltage fluctuating between - 1. 5 V and +1. 5 V can be pulled up to a voltage between 0 V and +3 V, so as to facilitate subsequent identification by the control module 110. Then, the adder may amplify the voltage at the positive input end based on a preset gain value, and the voltage detection module 130 further converts the amplified voltage into a voltage signal through an analog-to-digital converter, and transmits the voltage signal to the second input port of the control module 110.

The pot detection circuit 100 according to the embodiment of the application is applied to a wireless heating apparatus 200 used for heating a carried pot. The wireless heating apparatus 200 includes a heating coil, a first resistor R1 and a first capacitor C1 sequentially connected in series. The pot detection circuit 100 includes: a direction detection module 120 connected to two ends of the first resistor R1, and configured to detect a current direction of a current flowing through the first resistor R1; a voltage detection module 130 connected to an end of the first capacitor C1, and configured to detect a capacitor voltage of the first capacitor C1; and a control module 100 connected to the direction detection module 120 and the voltage detection module 130, and configured to determine a voltage amplitude of the first capacitor C1 according to a direction signal corresponding to the current direction input by the direction detection module 120 and a voltage signal corresponding to the capacitor voltage input by the voltage detection module 130, and determine whether the wireless heating apparatus 200 carries a pot according to a comparison result of the voltage amplitude and a preset amplitude. By obtaining an actual voltage amplitude of the first capacitor C1 connected in series with the coil, and determining whether the wireless heating apparatus 200 carries the pot based on the comparison result of the voltage amplitude and the preset amplitude, it is possible to avoid the interference of the external magnetic field, and obtain a more accurate pot detection result.

With reference to FIG. 4, it shows a schematic structural diagram of a power control circuit 300 according to an embodiment of the application. The power control circuit 300 is applied to a wireless heating apparatus 200 used for heating a carried pot. The wireless heating apparatus 200 includes a heating coil, a first resistor R1 and a first capacitor C1 sequentially connected in series. The power control circuit 300 includes: a direction detection module 320, connected to two ends of the first resistor R1, and configured to detect a current direction of a current flowing through the first resistor R1; a voltage detection module 330, connected to an end of the first capacitor C1, and configured to detect a capacitor voltage of the first capacitor C1; and a control module 310, connected to the direction detection module 320 and the voltage detection module 330, and configured to determine a voltage amplitude of the first capacitor C1 according to a direction signal corresponding to the current direction input by the direction detection module 320 and a voltage signal corresponding to the capacitor voltage input by the voltage detection module 330, and control a heating power of the wireless heating apparatus 200 according to a comparison result of the voltage amplitude and a target amplitude corresponding to a present heating power of the wireless heating apparatus 200.

In the embodiment of the application, during heating of the pot by the wireless heating apparatus 200, the control module 310 of the power control circuit 300 may obtain, through the direction detection module 320, the direction signal corresponding to the current direction of the current flowing through the first resistor R1 and obtain, through the voltage detection module 330, the voltage signal corresponding to the capacitor voltage of the first capacitor C1, determine the voltage amplitude of the first capacitor C1 based on the direction signal and the voltage signal, determine a material of the pot based on the voltage amplitude and determine a heating power of the wireless heating apparatus 200. It can be understood that since different pot materials have different inductance and resistance coupled to the coil. when a same power is generated by the wireless heating apparatus 200, the better the pot material, the more power the pot absorbs, the less the remaining power remains in the coil, and the smaller the voltage amplitude of the first capacitor C1 connected in series with the coil. In contrast, when the same power is generated by the wireless heating apparatus 200, if the material of the pot deteriorates, the voltage amplitude of the first capacitor C1 increases accordingly, that is to say, the current flowing through the circuit of the wireless heating apparatus 200 increases, and if the current becomes too large at this time, components such as Insulated Gate Bipolar transistors (IGBTs) in the circuit may be affected, or even the components may be broken down or damaged. Therefore, the control module 310 of the power control circuit 300 can detect the voltage amplitude corresponding to the first capacitor C1 in the wireless heating apparatus 200 in real time based on correspondences between voltage amplitudes and pot materials, indirectly determine the magnitude of the current in the circuit, and then adjust the heating power in real time to realize the protection of the circuit.

It can be understood that with the power control circuit 300, the basis data for determining the heating power can be converted from the number of current reversals to the voltage amplitude of the first capacitor C1, and the interference caused by the external magnetic field on the number of current reversals can be effectively avoided. Moreover, the determined voltage amplitude of the first capacitor C1 can be obtained in the process of heating the pot by the coil. That is to say, the control of the heating power can also be extended from the detection before heating to the real-time detection in the heating process, which can effectively cope with the change of the pot material caused by the movement of the pot during the heating process. Thus, the heating power of the wireless heating apparatus 200 is controlled more accurately, which further ensures the safety of the circuit in the wireless heating apparatus 200.

Specifically, the control module 310 of the power control circuit 300 is configured to decrease the heating power of the wireless heating apparatus 200 when the voltage amplitude is greater than the target amplitude, and maintain the present heating power of the wireless heating apparatus 200 unchanged when the voltage amplitude is smaller than or equal to the target amplitude.

That is to say, if the voltage amplitude corresponding to the first capacitor C1 is larger than the target amplitude, the control module 310 may determine that the magnitude of the current in the wireless heating apparatus 200 at this time exceeds a safety limit. Therefore, by reducing the heating power of the wireless heating apparatus 200, the current in the circuit of the wireless heating apparatus 200 is reduced with the same pot material, and the effect of protecting the circuit is realized. Similarly, if the voltage amplitude corresponding to the first capacitor C1 is not larger than the target amplitude, that is to say, with the present heating power, the current in the wireless heating apparatus 200 is within the safe limit range, so the control module 310 can keep the present heating power unchanged to heat the pot to the maximum extent. Herein, the control module 310 determines, through the target amplitude, whether the current in the wireless heating apparatus 200 exceeds the safety limit. The target amplitude may be a voltage amplitude corresponding to the first capacitor C1 in the circuit under the present heating power when the wireless heating apparatus 200 carries a pot having the best material. Herein, the pot having the best material may be an original pot of the wireless heating apparatus 200 or the pot capable of absorbing power with the best efficiency. Under the same present power condition, if the voltage amplitude of the first capacitor C1 is larger than the target amplitude, it indicates that the material of the pot is deteriorated, then the heating power of the wireless heating apparatus 200 may be reduced accordingly.

In some implementations, the control module 310 may divide a range of heating powers that the wireless heating apparatus 200 can generate into a limited number of grades in advance. In each grade, a maximum heating power in the grade is used as the heating power corresponding to the grade, and the control module 310 may determine a present heating grade based on a present heating power, and reduce the present heating grade by one when the voltage amplitude of the first voltage is greater than the target amplitude, so as to achieve the effect of reducing the heating power. Then, the control module 310 may still obtain the voltage amplitude corresponding to the first capacitor C1 after reducing the heating power, and if the voltage amplitude after the reducing is still larger than the target amplitude, the control module 310 may reduce the present heating grade again.

In some implementations, the direction signal includes a first direction signal and a second direction signal, and the control module 310 is configured to use, as a first peak signal, the voltage signal at a present time when a received direction signal changes from the second direction signal to the first direction signal, and use, as a second peak signal, the voltage signal at a present time when the received direction signal changes from the first direction signal to the second direction signal; and the control module 310 is further configured to determine the voltage amplitude of the first capacitor C1 based on the first peak signal and the second peak signal.

It can be understood that the voltage across the first capacitor C1 is alternating, and the voltage amplitude corresponding to the first capacitor C1 should be a difference between a maximum value of the positive half-cycle voltage across the first capacitor C1 and a maximum value of the negative half-cycle voltage. Therefore, the control module 310 can accurately determine occurrence times of the maximum value of the positive half-cycle voltage and the maximum value of the negative half-cycle voltage through the direction signals obtained by the direction detection module 320. That is to say, when the direction signal received by the control module 310 changes from the first direction signal to the second direction signal, the voltage signal across the first capacitor C1 at this time happens to be a peak signal, and the voltage signal at this time can be used as the first peak signal corresponding to the first capacitor C1. Similarly, when the direction signal changes from the second direction signal to the first direction signal, the voltage signal across the first capacitor C1 also happens to be a peak signal at this time, and the voltage signal at this time can be used as the second peak signal corresponding to the first capacitor C1. Thus, the control module 310 can determine the voltage amplitude of the first capacitor C1 based on the two different peak signals.

Specifically, the control module 310 may determine an absolute value of a difference between the first peak signal and the second peak signal, and use the absolute value as the voltage amplitude.

As can be seen, the first resistor R1 and the first capacitor C1 are connected in series, and the voltage across the first capacitor C1 happens to be at a peak value when the direction signal corresponding to the current direction of the first resistor R1 changes, so both the first peak signal and the second peak signal can represent peak values of the voltage signal across the first capacitor C1. Further, if the direction signals have different directions of change, the voltage signals across the first capacitor C1 will also have different directions, and thus the first peak signal and the second peak signal determined based on the different change situations of the direction signal are also different. In this way, the control module 310 may use the absolute value of the difference between the first peak signal and the second peak signal as the voltage amplitude corresponding to the first capacitor C1.

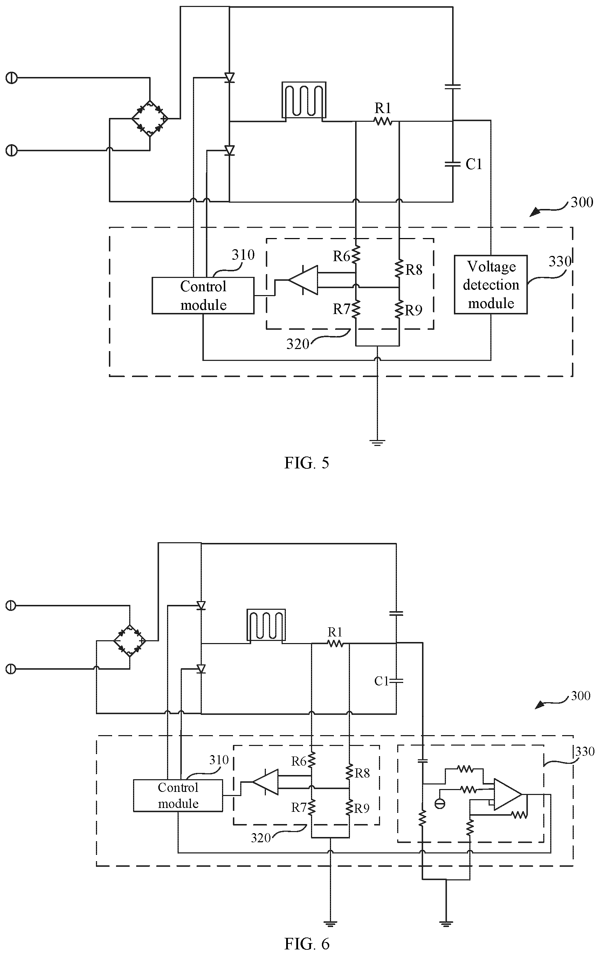

In the embodiment of the application, as shown in FIG. 5, the direction detection module 320 includes a first detection port, a second detection port, and a first output port. The first detection port is connected to a first end of the first resistor R1, the second detection port is connected to a second end of the first resistor R1, and the first output port is connected to a first input port of the control module 310; the direction detection module 320 is configured to obtain a first voltage at the first end of the first resistor R1 through the first detection port, and obtain a second voltage at the second end of the first resistor R1 through the second detection port; and the direction detection module 320 is further configured to output different direction signals to the first input port through the first output port according to a comparison result of the first voltage and the second voltage, the direction signal being used for characterizing the current direction of the current flowing through the first resistor R1.

It can be understood that the direction signal obtained by the control module 310 is used for characterizing the current direction of the current flowing through the first resistor R1, and it is obvious that the current direction of the current flowing through the first resistor R1 includes two directions. Therefore, the direction signal obtained by the control module 310 also includes the first direction signal and the second direction signal, which are respectively used for characterizing different current directions of the current flowing through the first resistor R1. Herein, the direction detection module 320 may obtain a voltage at the first end of the first resistor R1 through the first detection port, and obtain a voltage at the second end of the first resistor R1 through the second detection port; and determine current directions of the current flowing through the first resistor R1 at different times through a relation between voltages at both ends of the first resistor R1.

In some implementations, the direction detection module 320 may include a sixth resistor R6 and a seven resistor R7. One end of the seventh resistor R7 is grounded, and the other end of the seventh resistor R7 is connected to one end of the sixth resistor R6 and the first detection port of the direction detection module 320. The other end of the sixth resistor R6 is connected to the first end of the first resistor R1. The direction detection module 120 may obtain, as the first voltage, the voltage at the first end of the first resistor R1 after voltage dividing through the sixth resistor R6 and the seventh resistor R7. Similarly, the direction detection module 320 may further include a eighth resistor R8 and a ninth resistor R9. One end of the ninth resistor R9 is grounded, and the other end of the ninth resistor R9 is connected to one end of the eighth resistor R8 and the second detection port of the direction detection module 320. The other end of the eighth resistor R8 is connected to the second end of the first resistor R1. The direction detection module 320 may obtain, as the second voltage, the voltage at the second end of the first resistor R1 after voltage dividing through the eighth resistor R8 and the ninth resistor R9.

In some implementations, the direction detection circuit 320 may further includes a first comparator, a positive input end of the first comparator serving as the first detection port, a negative input end of the first comparator serving as the second detection port, and an output end of the first comparator serving as the first output port of the direction detection module 320. When the first voltage obtained by the positive input end is larger than the second voltage obtained by the negative input end, the first comparator may output a first level signal to the first input port of the control module 310 through the output end, and at this time, the first level signal may be used as the first direction signal. Moreover, when the first voltage obtained by the positive input end is less than or equal to the second voltage obtained by the negative input end, the first comparator may output a second level signal to the first input port of the control module 310 through the output end, and at this time, the second level signal may be used as the second direction signal. Accordingly, the direction detection module 320 may obtain the current direction of the current flowing through the first resistor R1 in real time, and output the current direction to the control module 310 in the form of the first direction signal and the second direction signal.

In the embodiment of the application, as shown in FIG. 6, the direction detection module 330 includes a third detection port and a second output port. The third detection port is connected to the end of the first capacitor C1, and the second output port is connected to a second input port of the control module 310. The direction detection module 330 is configured to obtain the capacitor voltage of the first capacitor C1 through the third detection port, and transmit the voltage signal corresponding to the capacitor voltage to the second input port through the second output port.

It can be understood that the voltage signal obtained by the control module 310 should be a digital signal, and the voltage detection module 330 is connected between the control module 310 and the first capacitor C1, it is then necessary to convert the analog voltage signal across the first capacitor C1 into a digital voltage signal that can be recognized by the control module 310. Specifically, the voltage detection module 330 may include an adder, one input port of a positive input end of the adder may be connected to one end of the first capacitor C1 as the third detection port, and the other input port of the positive input end of the adder may be connected to an external power source. As can be understood, the control module 310 cannot recognize a negative voltage, and the voltage at the first capacitor C1 varies in the form of a sine wave between a maximum voltage value and a minimum voltage value, where the minimum voltage value is negative, for example, the voltage at the first capacitor C1 may fluctuate in the form of a sine wave between - 1. 5 V and +1.5 V. At this time, the adder can pull up the voltage at the positive input end of the adder to a positive voltage through the external power supply connected to the other input port, for example, the voltage fluctuating between - 1. 5 V and +1. 5 V can be pulled up to a voltage between 0 V and +3 V, so as to facilitate subsequent identification by the control module 310. Then, the adder may amplify the voltage at the positive input end based on a preset gain value, and the voltage detection module 330 further converts the amplified voltage into a voltage signal through an analog-to-digital converter, and transmits the voltage signal to the second input port of the control module 310.

The embodiment of the application provides a power control circuit 300 includes: a direction detection module 320, a voltage detection module 330 and a control module 310. The control module 310 is connected to the direction detection module 320 and the voltage detection module 330, and configured to determine a voltage amplitude of the first capacitor C1 according to according to: a direction signal corresponding to a current direction of a current flowing through a first resistor R1, which is input by the direction detection module 320, and a voltage signal corresponding to a capacitor voltage of the first capacitor C1, which is input by the voltage detection module 330; and control a heating power of the wireless heating apparatus 200 according to a comparison result of the voltage amplitude and a target amplitude corresponding to a present heating power of the wireless heating apparatus 200. Through the comparison result of the real-time voltage amplitude and the target amplitude, it is possible to determine the change of the material of the pot during the heating process, and then adjust the heating power of the wireless heating apparatus 200 in real time to ensure that the current in the wireless heating apparatus 200 is always within a safe range, so as to achieve the effect of protecting the wireless heating apparatus 200.

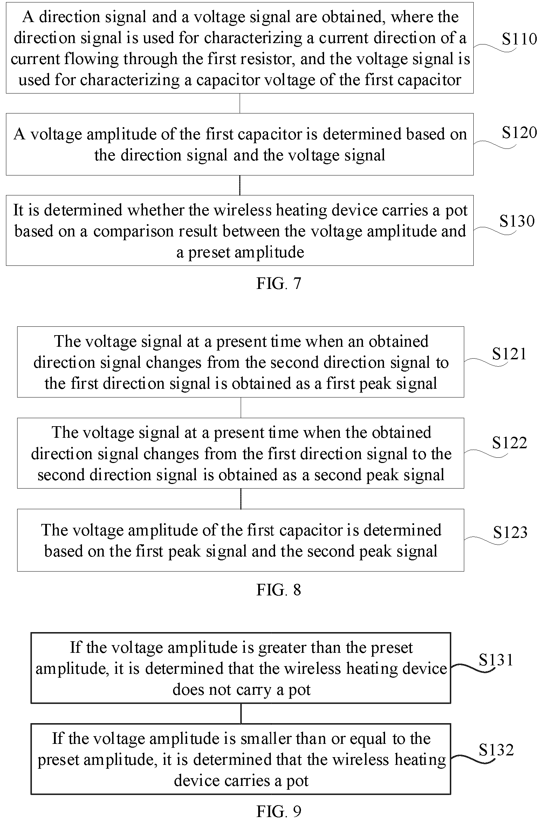

With reference to FIG. 7, it is a schematic flowchart of a pot detection method according to an embodiment of the application. The method is applied to a wireless heating apparatus for heating a carried pot, and the wireless heating apparatus includes a heating coil, and a first resistor and a first capacitor connected in series with the heating coil. Hereinafter, power control is described in more detail with reference to the flowchart in FIG. 7, and the pot detection method may specifically include the following operations.

In operation S110, a direction signal and a voltage signal are obtained, where the direction signal is used for characterizing a current direction of a current flowing through the first resistor, and the voltage signal is used for characterizing a capacitor voltage of the first capacitor.

In the embodiment of the application, the controller may obtain the direction signal for characterizing the current direction of the current in the wireless heating apparatus through the direction detection module, and may further obtain the voltage signal for characterizing the capacitor voltage at one end of the first capacitor through the voltage detection module, and determine the voltage amplitude of the first capacitor based on the direction signal and the voltage signal. When the current direction of the current flowing through the first resistor changes, the capacitor voltage of the first capacitor reaches the peak value. Therefore, the controller can determine the change time of the current direction in the circuit through the direction signal used to characterize the current direction, and then determine a time when the capacitor voltage reaches the peak value, so as to determine the voltage amplitude of the first capacitor through the peak value of the capacitor voltage.

In operation S120, a voltage amplitude of the first capacitor is determined based on the direction signal and the voltage signal.

In the embodiment of the application, the controller may obtain a time when the current direction in the circuit of the wireless heating apparatus changes each time based on the direction signal, and may further use the capacitor voltage of the first capacitor obtained at the time when the current direction changes each time as one of the peak voltages of the first capacitor. It can be understood that the current direction in the circuit includes two kinds: positive direction and negative direction, thus the controller can respectively characterize different current directions through two different direction signals. When the direction signal received by the controller changes, it means that the current direction in the circuit changes. Moreover, since the capacitor voltage at one end of the first capacitor fluctuates in the form of a sine wave, the peak voltage of the capacitor voltage of the first capacitor includes a positive peak voltage and a negative peak voltage. Therefore, when a predetermined change of the current direction occurs, the controller can take the capacitor voltage at one end of the first capacitor at the present time as one of the peak voltages to determine the voltage amplitude corresponding to the first capacitor.

In some implementations, as shown in FIG. 8, the direction signal includes a first direction signal and a second direction signal, and the operation that a voltage amplitude of the first capacitor is determined based on the direction signal and the voltage signal may be implemented through following operations S121 to S123.

In operation S121, the voltage signal at a present time when an obtained direction signal changes from the second direction signal to the first direction signal is obtained as a first peak signal.

In operation S122, the voltage signal at a present time when the obtained direction signal changes from the first direction signal to the second direction signal is obtained as a second peak signal.

In the embodiment of the application, the controller may divide the direction signal into a first direction signal and a second direction signal according to the actual current direction in the circuit, which are respectively used to characterize different current directions of currents flowing through the first resistor. For example, the first directional signal may characterize the flow of the current from the first end of the first resistor to the second end of the first resistor, then the second directional signal is used to characterize the flow of the current from the second end of the first resistor to the first end of the first resistor. From the above analysis, it can be seen that when the direction signal received by the controller changes, the capacitor voltage at one end of the first capacitor reaches the peak value. Moreover, since the capacitor voltage fluctuates in the form of sine wave, the capacitor voltage includes two different peak voltages, i. e., positive peak value and negative peak value. Therefore, the controller can take, the voltage signal at the present time when the direction signal is converted from the second direction signal to the first direction signal, as the first peak signal; and take, the voltage signal at the present time when the direction signal is converted from the first direction signal to the second direction signal, as the peak value. Accordingly, the controller can obtain peak signals corresponding to two different peak voltages corresponding to the capacitor voltage of the first capacitor, and determine the voltage amplitude corresponding to the first capacitor.

In operation S123, the voltage amplitude of the first capacitor is determined based on the first peak signal and the second peak signal.

In the embodiment of the application, after determining the first peak signal and the second peak signal, the controller may use an absolute value of a difference between the first peak signal and the second peak signal as the voltage amplitude corresponding to the first capacitor. As can be seen, the first peak signal and the second peak signal are signals in opposite directions. Due to the different directions of change of the current flowing through the first resistor, the capacitor voltage at one end of the first capacitor is also correspondingly at different peaks. The controller can determine the voltage amplitude of the first capacitor according to the two peak signals in opposite directions.

In some implementations, the controller may take the absolute value of the difference between the first peak signal and the second peak signal as the voltage amplitude of the first capacitor.

In operation S130, it is determined whether the wireless heating apparatus carries a pot based on a comparison result of the voltage amplitude and a preset amplitude.

In the embodiment of the application, the wireless heating apparatus is caused in advance to carry pots of different material types under the same heating power, so that the controller may obtain different voltage amplitudes corresponding to the first capacitor, and determine, based on these amplitudes, a boundary amplitude of the voltage amplitude of the first capacitor to distinguish between when the wireless heating apparatus carries a pot and when it does not carry a pot, that is, determine the preset amplitude. A median value of all voltage amplitudes can be regarded as the boundary amplitude between carrying a pot and not carrying a pot, namely, the preset amplitude. In order to ensure the circuit safety of the wireless heating apparatus, through the operations above, the controller may obtain an actual voltage amplitude at one end of the first capacitor at the present time, compare the actual voltage amplitude with the preset amplitude, and accurately determine whether the wireless heating apparatus carries a pot.

In some implementations, as shown in FIG. 9, the operation that the controller determines whether the wireless heating apparatus carries a pot based on a comparison result of the voltage amplitude and a preset amplitude may be implemented through operations S131 to S132.

In operation S131, if the voltage amplitude is greater than the preset amplitude, it is determined that the wireless heating apparatus does not carry a pot.

In operation S132, if the voltage amplitude is smaller than or equal to the preset amplitude, it is determined that the wireless heating apparatus carries a pot.

In the embodiment of the application, if the actual voltage amplitude corresponding to the first capacitor in the circuit of the wireless heating apparatus is larger than the preset amplitude, it indicates that since there is no external pot or the like to absorb the power in the circuit through the coil, and the current in the circuit becomes large, so the actual voltage amplitude of the first capacitor is relatively large. At this time, the controller may determine that the wireless heating apparatus does not carry a pot. On the other hand, if the actual voltage amplitude corresponding to the first capacitor is less than or equal to the preset amplitude, it indicates that at this time, the voltage amplitude at both ends of the first capacitor connected in series with the coil is small because the external pot or the like absorbs most of the power in the circuit of the wireless heating apparatus, so the controller can directly determine that the wireless heating apparatus carries a pot when the voltage amplitude of the first capacitor is less than or equal to the preset amplitude.

According to the pot detection method provided herein, the voltage amplitude of the first capacitor is determined by obtaining the direction signal for characterizing the current direction of the current flowing through the first resistor and the voltage signal for characterizing the capacitor voltage of the first capacitor, and then it is determined whether the wireless heating apparatus carries a pot based on a comparison result of the voltage amplitude and the preset amplitude. By determining whether the wireless heating apparatus carries a pot based on the comparison result of the actual voltage amplitude of the first capacitor and the preset amplitude, it is possible to avoid the interference of the external magnetic field on the number of current reversals of the coil, and obtain a more accurate pot detection result.

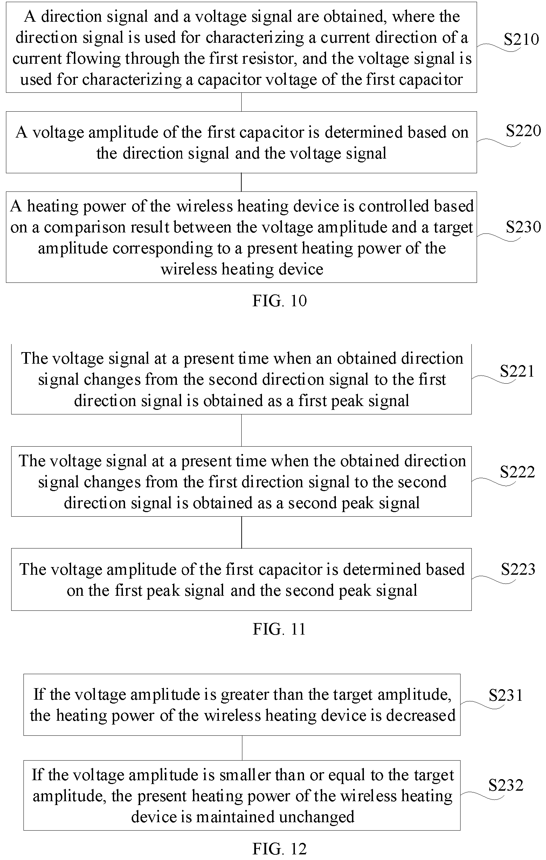

With reference to FIG. 10, it is a schematic flowchart of a power control method according to an embodiment of the application. The method is applied to a wireless heating apparatus for heating a carried pot, and the wireless heating apparatus includes a heating coil, and a first resistor and a first capacitor connected in series with the heating coil. Hereinafter, the flowchart in FIG. 10 will be described in detail, and the pot detection method may specifically include the following operations.

In operation S210, a direction signal and a voltage signal are obtained, where the direction signal is used for characterizing a current direction of a current flowing through the first resistor, and the voltage signal is used for characterizing a capacitor voltage of the first capacitor.

In the embodiment of the application, the control module of the wireless heating apparatus may obtain the direction signal for characterizing the current direction of the current in the wireless heating apparatus through the direction detection module, and may further obtain the voltage signal for characterizing the capacitor voltage at one end of the first capacitor through the voltage detection module, and determine the voltage amplitude of the first capacitor based on the direction signal and the voltage signal. When the current direction of the current flowing through the first resistor changes, the capacitor voltage of the first capacitor reaches the peak value. Therefore, the control module needs to determine the change time of the current direction in the circuit through the direction signal used to characterize the current direction, and then determine a time when the capacitor voltage reaches the peak value, so as to determine the voltage amplitude of the first capacitor through the peak value of the capacitor voltage.

In operation S220, a voltage amplitude of the first capacitor is determined based on the direction signal and the voltage signal.

In the embodiment of the application, the control module may obtain a time when the current direction in the circuit of the wireless heating apparatus changes each time based on the direction signal, and may further use the capacitor voltage at one end of the first capacitor obtained at the time when the current direction changes each time as one of the peak voltages of the first capacitor. It can be understood that the current direction in the circuit includes two kinds: positive direction and negative direction, thus the control module can respectively characterize different current directions through two different direction signals. When the direction signal received by the control module changes, it means that the current direction in the circuit changes. Moreover, since the capacitor voltage at one end of the first capacitor fluctuates in the form of a sine wave, the capacitor voltage at one end of the first capacitor includes a positive peak voltage and a negative peak voltage. Therefore, when a predetermined change of the current direction occurs, the control module can take the capacitor voltage at one end of the first capacitor at the present time as one of the peak voltages to determine the voltage amplitude corresponding to the first capacitor.

In some implementations, as shown in FIG. 11, the direction signal includes a first direction signal and a second direction signal, and the operation that a voltage amplitude of the first capacitor is determined based on the direction signal and the voltage signal may be implemented through following operations S221 to S223.

In operation S221, the voltage signal at a present time when an obtained direction signal changes from the second direction signal to the first direction signal is obtained as a first peak signal.

In operation S222, the voltage signal at a present time when the obtained direction signal changes from the first direction signal to the second direction signal is obtained as a second peak signal.

In the embodiment of the application, the control module may divide the direction signal into a first direction signal and a second direction signal according to the actual current direction in the circuit, which are respectively used to characterize different current directions of currents flowing through the first resistor. For example, the first directional signal may characterize the flow of the current from the first end of the first resistor to the second end of the first resistor, then the second directional signal is used to characterize the flow of the current from the second end of the first resistor to the first end of the first resistor. From the above analysis, it can be seen that when the direction signal received by the control module changes, the capacitor voltage at one end of the first capacitor reaches the peak value. Moreover, since the capacitor voltage fluctuates in the form of sine wave, the capacitor voltage includes two different peak voltages, i. e., positive peak value and negative peak value. Therefore, the control module can take, the voltage signal at the present time when the direction signal is converted from the second direction signal to the first direction signal, as the first peak signal; and take, the voltage signal at the present time when the direction signal is converted from the first direction signal to the second direction signal, as the peak value. Accordingly, the control module can obtain peak signals corresponding to two different peak voltages corresponding to the capacitor voltage of the first capacitor, and determine the voltage amplitude corresponding to the first capacitor.

In operation S223, the voltage amplitude of the first capacitor is determined based on the first peak signal and the second peak signal.

In the embodiment of the application, after determining the first peak signal and the second peak signal, the control module may use an absolute value of a difference between the first peak signal and the second peak signal as the voltage amplitude corresponding to the first capacitor. As can be seen, the first peak signal and the second peak signal are signals in opposite directions. Due to the different directions of change of the current flowing through the first resistor, the capacitor voltage at one end of the first capacitor is also correspondingly at different peaks. The control module can determine the voltage amplitude of the first capacitor according to the two peak signals in opposite directions.

In some implementations, the control module may take the absolute value of the difference between the first peak signal and the second peak signal as the voltage amplitude of the first capacitor.

In operation S230, a heating power of the wireless heating apparatus is controlled based on a comparison result of the voltage amplitude and a target amplitude corresponding to a present heating power of the wireless heating apparatus.

In the embodiment of the application, the control module may determine the target amplitude based on the present heating power. That is to say, in a case where the material of the carried pot is an ideal material, when the wireless heating apparatus performs heating with the present heating power, the voltage amplitude of the first capacitor in the circuit is used as the target amplitude. Moreover, in order to protect the circuit, the control module can also determine, by the operations above, the actual voltage amplitude at one end of the first capacitor when heating is performed using the present heating power, and compare the actual voltage amplitude with the expected target amplitude, thereby determine whether the material of the pot carried by the wireless heating apparatus has changed at this time.

In some implementations, as shown in FIG. 12, the operation that the control module controls a heating power of the wireless heating apparatus based on a comparison result of the voltage amplitude and a target amplitude corresponding to a present heating power of the wireless heating apparatus may be implemented through the flowing operations S231 to S232.

In operation S231, if the voltage amplitude is greater than the target amplitude, the heating power of the wireless heating apparatus is decreased.

In operation S232, if the voltage amplitude is smaller than or equal to the target amplitude, the present heating power of the wireless heating apparatus is maintained unchanged.

In the embodiment of the application, if the actual voltage amplitude corresponding to the first capacitor is larger than the target amplitude in the circuit of the wireless heating apparatus, it indicates that the material of the pot carried at this time becomes worse. This may be caused due to the fact that the user keeps the pot away from the wireless heating apparatus, or the user replaces the original pot with another one. In short, the heating power absorbed by the pot becomes less, resulting in a large current in the wireless heating apparatus. If the heating power is not changed at this time, the large current may damage circuit components. Thus, in this case, the control module may decrease the heating power of the wireless heating apparatus to reduce the current in the circuit so as to protect the circuit components. Another case is that the voltage amplitude is less than or equal to the target amplitude. In this case, the material of the pot carried by the wireless heating apparatus becomes better, this may be caused due to the fact that the user reduces a distance between the pot and the wireless heating apparatus, or the user changes the pot to a pot with a better material. In short, the heating power absorbed by the pot becomes more, and the current in the wireless heating apparatus becomes less. The safety of circuit components is not affected in this case, and the pot has a better heating effect due to the increase in the heating power absorbed by the pot. Therefore, there is no need for the control module to change the heating power, i.e., the heating power of the wireless heating apparatus remains unchanged.

In some implementations, if the actual voltage amplitude corresponding to the first capacitor in the circuit of the wireless heating apparatus is greater than the target amplitude, the control module may determine a decreasing amplitude of the heating power of the wireless heating apparatus based on a difference between the voltage amplitude and the target amplitude. That is to say, in a case where the voltage amplitude is larger than the target amplitude, the larger the difference between the voltage amplitude and the target amplitude, the larger the decreasing amplitude of the heating power of the wireless heating apparatus made by the control module. Of course, the decreasing amplitude of the heating power needs to be kept within a preset safety range, and if it exceeds this preset safety range, the control module can output a warning information to inform the user that the pot carried at this time cannot be heated.

According to the power control method provided herein, the voltage amplitude of the first capacitor is determined by obtaining the direction signal for characterizing the current direction of the current flowing through the first resistor and the voltage signal for characterizing the capacitor voltage of the first capacitor, and then the heating power of the wireless heating apparatus is controlled based on a comparison result of the voltage amplitude and the target amplitude corresponding to the present heating power of the wireless heating apparatus. Through the relationship between of the real-time voltage amplitude at one end of the first capacitor and the target amplitude corresponding to the present heating power, it is possible to determine the change of the material of the carried pot during the heating process, and then adjust the heating power of the wireless heating apparatus in real time to ensure that the current in the wireless heating apparatus is always within a safe range, so as to achieve the effect of protecting the wireless heating apparatus.

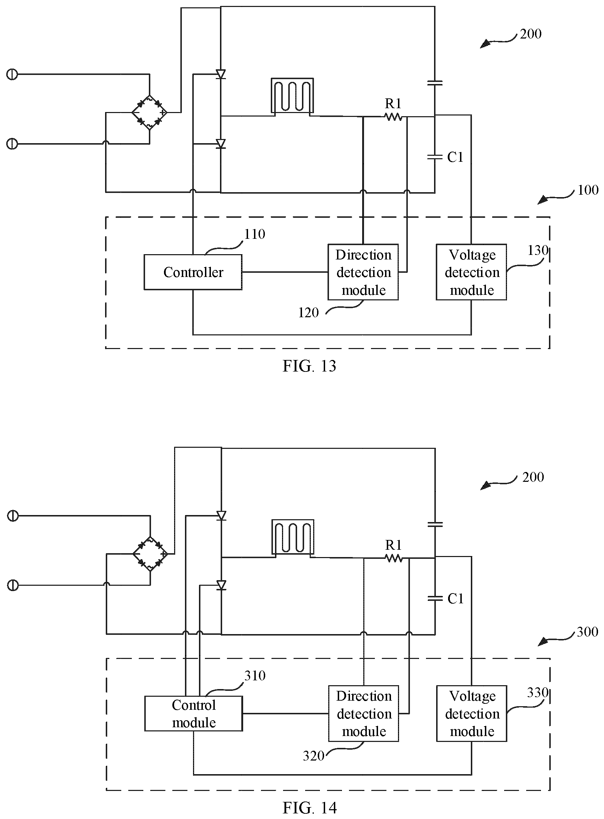

With reference to FIG. 13, it shows a schematic structural diagram of the wireless heating apparatus 200 according to an embodiment of the application. The device includes a heating coil, a first resistor R1, a first capacitor C1, and a pot detection circuit 100 according to the embodiment above. The heating coil, the first resistor R1 and the first capacitor C1 are sequentially connected in series. The pot detection circuit 100 may obtain a direction signal for characterizing the current direction of the current flowing through the first resistor R1 and a voltage signal for characterizing the capacitor voltage of the first capacitor C1, determine the voltage amplitude of the first capacitor C1 based on the direction signal and the voltage signal, and further determine that the wireless heating apparatus 200 does not carry a pot when the voltage amplitude is greater than the preset amplitude, and determine that the wireless heating apparatus 200 carries a pot when the voltage amplitude is less than or equal to the preset amplitude. The determination of the existence or absence of a pot is implemented by detecting the voltage amplitude of the first capacitor C1, it is thus possible to avoid the influence of the external magnetic field on the wireless heating apparatus 200, so that the pot detection result can be more accurate.

With reference to FIG. 14, it shows another schematic structural diagram of the wireless heating apparatus 200 according to an embodiment of the application. The device includes a heating coil, a first resistor R1, a first capacitor C1, and a power control circuit 300 as provided in the embodiment above. The heating coil, the first resistor R1 and the first capacitor C1 are sequentially connected in series. The power control circuit 300 may obtain the direction signal for characterizing the current direction of the current flowing through the first resistor R1 and the voltage signal for characterizing the capacitor voltage of the first capacitor C1; determine the change of material of the pot during the heating process based on the comparison result of the voltage amplitude and the target amplitude corresponding to the present heating power of the wireless heating apparatus 200; and adjust the heating power of the wireless heating apparatus 200 in real time to ensure the current in the wireless heating apparatus 200 is always within a safe range, so as to achieve the effect of protecting the wireless heating apparatus 200.

Finally, it is to be noted that the above embodiments are merely used to illustrate the technical solutions of the application, and are not intended to limit them. Although the application has been described in detail with reference to the aforementioned embodiments, those skilled in the art will understand that the technical solutions described in the aforementioned embodiments may be modified or some technical features may be equivalently replaced. These modifications or substitutions do not cause the essence of the corresponding technical solutions to deviate from the spirit and scope of the technical solutions of respective embodiments of the application.

## Claims

1. A pot detection circuit, applied to a wireless heating apparatus used for heating a carried pot, wherein the wireless heating apparatus comprises a heating coil, a first resistor and a first capacitor sequentially connected in series, and the pot detection circuit comprises:
a direction detection module, connected to two ends of the first resistor, and configured to detect a current direction of a current flowing through the first resistor;
a voltage detection module, connected to an end of the first capacitor, and configured to detect a capacitor voltage of the first capacitor; and
a control module connected to the direction detection module and the voltage detection module, wherein the control module is configured to determine a voltage amplitude of the first capacitor according to a direction signal corresponding to the current direction input by the direction detection module and a voltage signal corresponding to the capacitor voltage input by the voltage detection module, and determine whether the wireless heating apparatus carries a pot according to a comparison result of the voltage amplitude and a preset amplitude.

2. The pot detection circuit of claim 1, wherein the control module is further configured to determine that the wireless heating apparatus does not carry a pot when the voltage amplitude is greater than the preset amplitude, and determine that the wireless heating apparatus carries a pot when the voltage amplitude is less than or equal to the preset amplitude.

3. The pot detection circuit of claim 1, wherein:
the direction signal comprises a first direction signal and a second direction signal, and the control module is further configured to use, as a first peak signal, the voltage signal at a present time when a received direction signal changes from the second direction signal to the first direction signal, and use, as a second peak signal, the voltage signal at a present time when the received direction signal changes from the first direction signal to the second direction signal; and
the control module is further configured to determine the voltage amplitude of the first capacitor based on the first peak signal and the second peak signal.

4. The pot detection circuit of claim 3, wherein the control module is further configured to determine an absolute value of a difference between the first peak signal and the second peak signal, and use the absolute value as the voltage amplitude.

5. The pot detection circuit of any one of claims 1 to 4, wherein:
the direction detection module comprises a first detection port, a second detection port, and a first output port;
the first detection port is connected to a first end of the first resistor, the second detection port is connected to a second end of the first resistor, and the first output port is connected to a first input port of the control module;
the direction detection module is configured to obtain a first voltage at the first end of the first resistor through the first detection port, and obtain a second voltage at the second end of the first resistor through the second detection port; and
the direction detection module is further configured to output different direction signals to the first input port through the first output port according to a comparison result of the first voltage and the second voltage, the direction signal being used for characterizing the current direction of the current flowing through the first resistor.

6. The pot detection circuit of any one of claims 1 to 4, wherein:
the direction detection module comprises a third detection port and a second output port, the third detection port is connected to the end of the first capacitor, and the second output port is connected to a second input port of the control module; and
the direction detection module is configured to obtain the capacitor voltage of the first capacitor through the third detection port, and transmit the voltage signal corresponding to the capacitor voltage to the second input port through the second output port.

7. The power control circuit of any one of claims 1 to 4, wherein:
the direction detection circuit comprises a first comparator, a positive input end of the first comparator serving as the first detection port, a negative input end of the first comparator serving as the second detection port, and an output end of the first comparator serving as the first output port;
the first comparator is configured to obtain the first voltage through the positive input end, and obtain the second voltage through the negative input end; and
the first comparator is further configured to output the first direction signal through the output end when the first voltage is greater than the second voltage, and output the second direction signal through the output end when the first voltage is less than or equal to the second voltage.

8. A power control circuit, applied to a wireless heating apparatus used for heating a carried pot, wherein the wireless heating apparatus comprises a heating coil, a first resistor and a first capacitor sequentially connected in series, and the power control circuit comprises:
a direction detection module, connected to two ends of the first resistor, and configured to detect a current direction of a current flowing through the first resistor;
a voltage detection module, connected to an end of the first capacitor, and configured to detect a capacitor voltage of the first capacitor; and
a control module connected to the direction detection module and the voltage detection module, wherein the control module is configured to determine a voltage amplitude of the first capacitor according to a direction signal corresponding to the current direction input by the direction detection module and a voltage signal corresponding to the capacitor voltage input by the voltage detection module, and control a heating power of the wireless heating apparatus according to a comparison result of the voltage amplitude and a target amplitude corresponding to a present heating power of the wireless heating apparatus.

9. The power control circuit of claim 8, wherein the control module is configured to decrease the heating power of the wireless heating apparatus when the voltage amplitude is greater than the target amplitude, and maintain the present heating power of the wireless heating apparatus unchanged when the voltage amplitude is smaller than or equal to the target amplitude.

10. The power control circuit of claim 8, wherein:
the direction signal comprises a first direction signal and a second direction signal, and the control module is configured to use, as a first peak signal, the voltage signal at a present time when a received direction signal changes from the second direction signal to the first direction signal, and use, as a second peak signal, the voltage signal at a present time when the received direction signal changes from the first direction signal to the second direction signal; and
the control module is further configured to determine the voltage amplitude of the first capacitor based on the first peak signal and the second peak signal.

11. The power control circuit of claim 8, wherein the control module is further configured to determine an absolute value of a difference between the first peak signal and the second peak signal, and use the absolute value as the voltage amplitude.

12. The power control circuit of any one of claims 8 to 11, wherein:
the direction detection module comprises a first detection port, a second detection port, and a first output port, the first detection port is connected to a first end of the first resistor, the second detection port is connected to a second end of the first resistor, and the first output port is connected to a first input port of the control module;
the direction detection module is configured to obtain a first voltage at the first end of the first resistor through the first detection port, and obtain a second voltage at the second end of the first resistor through the second detection port; and
the direction detection module is further configured to output different direction signals to the first input port through the first output port according to a comparison result of the first voltage and the second voltage, the direction signal being used for characterizing the current direction of the current flowing through the first resistor.

13. The power control circuit of any one of claims 8 to 11, wherein:
the direction detection module comprises a third detection port and a second output port, the third detection port is connected to the end of the first capacitor, and the second output port is connected to a second input port of the control module; and
the direction detection module is configured to obtain the capacitor voltage of the first capacitor through the third detection port, and transmit the voltage signal corresponding to the capacitor voltage to the second input port through the second output port.

14. A pot detection method, applied to a wireless heating apparatus for heating a carried pot, the wireless heating apparatus comprising a heating coil, and a first resistor and a first capacitor connected in series with the heating coil, the method comprising:
obtaining a direction signal and a voltage signal, wherein the direction signal is used for characterizing a current direction of a current flowing through the first resistor, and the voltage signal is used for characterizing a capacitor voltage of the first capacitor;
determining a voltage amplitude of the first capacitor based on the direction signal and the voltage signal; and
determining whether the wireless heating apparatus carries a pot based on a comparison result of the voltage amplitude and a preset amplitude.

15. The method of claim 14, wherein said determining whether the wireless heating apparatus carries a pot based on a comparison result of the voltage amplitude and a preset amplitude comprises:
if the voltage amplitude is greater than the preset amplitude, determining that the wireless heating apparatus does not carry a pot; and
if the voltage amplitude is smaller than or equal to the preset amplitude, determining that the wireless heating apparatus carries a pot.

16. The method of claim 14, wherein the direction signal comprises a first direction signal and a second direction signal, and said determining a voltage amplitude of the first capacitor based on the direction signal and the voltage signal comprises:
obtaining, as a first peak signal, the voltage signal at a present time when an obtained direction signal changes from the second direction signal to the first direction signal;
obtaining, as a second peak signal, the voltage signal at a present time when the obtained direction signal changes from the first direction signal to the second direction signal; and
determining the voltage amplitude of the first capacitor based on the first peak signal and the second peak signal.

17. A power control method, applied to a wireless heating apparatus for heating a carried pot, the wireless heating apparatus comprising a heating coil, and a first resistor and a first capacitor connected in series with the heating coil, the method comprising:
obtaining a direction signal and a voltage signal, wherein the direction signal is used for characterizing a current direction of a current flowing through the first resistor, and the voltage signal is used for characterizing a capacitor voltage of the first capacitor;
determining a voltage amplitude of the first capacitor based on the direction signal and the voltage signal; and
controlling a heating power of the wireless heating apparatus based on a comparison result of the voltage amplitude and a target amplitude corresponding to a present heating power of the wireless heating apparatus.

18. The method of claim 17, wherein said controlling a heating power of the wireless heating apparatus based on a comparison result of the voltage amplitude and a target amplitude corresponding to a present heating power of the wireless heating apparatus comprises:
if the voltage amplitude is greater than the target amplitude, decreasing the heating power of the wireless heating apparatus;
if the voltage amplitude is smaller than or equal to the target amplitude, maintaining the present heating power of the wireless heating apparatus unchanged.

19. A wireless heating apparatus, comprising a heating coil, a first resistor, a first capacitor, and a pot detection circuit of any one of claims 1 to 7, wherein the heating coil, the first resistor and the first capacitor are sequentially connected in series.

20. A wireless heating apparatus, comprising a heating coil, a first resistor, a first capacitor, and a power control circuit of any one of claims 8 to 13, wherein the heating coil, the first resistor and the first capacitor are sequentially connected in series.
